# EUROPEAN PATENT SPECIFICATION

(11) **EP 1 691 416 B1**
(45) Date of publication and mention of the grant of the patent: **13.01.2010**
(21) Application number: 06250390.9
(22) Date of filing: 25.01.2006
(51) Int. Cl.: H01L 27/146

(54) **Salicide process for image sensor**
Salizidprozess für Bildsensor
Procédé salicide pour capteur d'image

(30) Priority: 14.02.2005 US 58117
(43) Date of publication of application: 16.08.2006
(73) Proprietor: OmniVision Technologies, Inc., Sunnyvale, California 94089 (US)
(72) Inventor: Rhodes, Howard E., Boise, Idaho 83706 (US)
(74) Representative: Hackney, Nigel John

(56) References cited:
- US-A1- 2001 022 371
- US-A1- 2004 051 123
- US-B1- 6 194 258
- US-B1- 6 448 595
- US-B1- 6 642 076

## Description

The present invention relates to image sensors, and more particularly, to an image sensor that uses a salicide process.

Image sensors have become ubiquitous. They are widely used in digital still cameras, cellular phones, security cameras, medical, automobile, and other applications. The technology used to manufacture image sensors, and in particular CMOS image sensors, has continued to advance at great pace. For example, the demands of higher resolution and lower power consumption have encouraged the further miniaturization and integration of the image sensor.

With the further integration, an important aspect of image sensor performance is the ability to read out quickly the signals from the pixel array. It is not unusual for a pixel array to include over five million separate pixels. Many image sensors use a metal salicide process to improve the speed of the periphery transistors and to provide a low resistance routing line and a local interconnect.

However, it is known in the prior art that the photodiode sensor region should be protected from the salicidation. If the photodiode were to be salicided (typically with a cobalt or titanium salicide), the performance of the image sensor would be degraded. Specifically, a cobalt or titanium salicide (CoSi₂ or TiSi₂) is opaque to light and would thus block light from the underlying photodiode, decreasing sensitivity. Further, the salicide would also increase dark current. For these reasons, a protective coating (typically oxide or nitride or an oxide-nitride composite film) is placed over the photodiode and often over the entire imaging array to protect the sensitive regions during the salicide process.

Still, there is substantial yield loss due to transistor gates that are not completely salicided, which results in an increase in the RC time constant for those gates which make the image sensor nearly inoperable. Gate response time to voltage driving pulses are slowed to the point that they do not respond at the correct timing intervals in the designed circuit. This is particularly an issue with transistor gates that are long and/or wide and that are not uniformly salicided across the entire wafer.

Document US-B-6 194 258 discloses a salicide process for an image sensor.

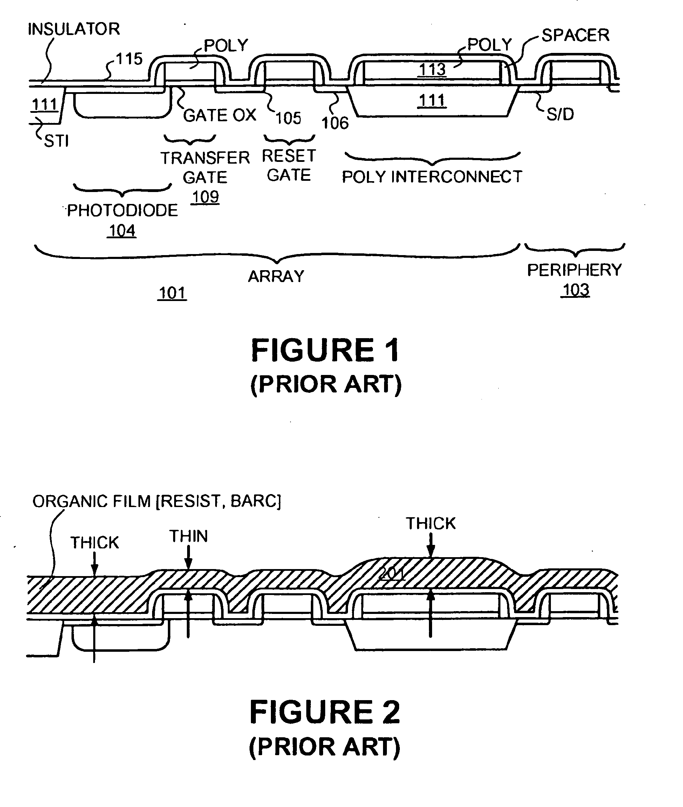

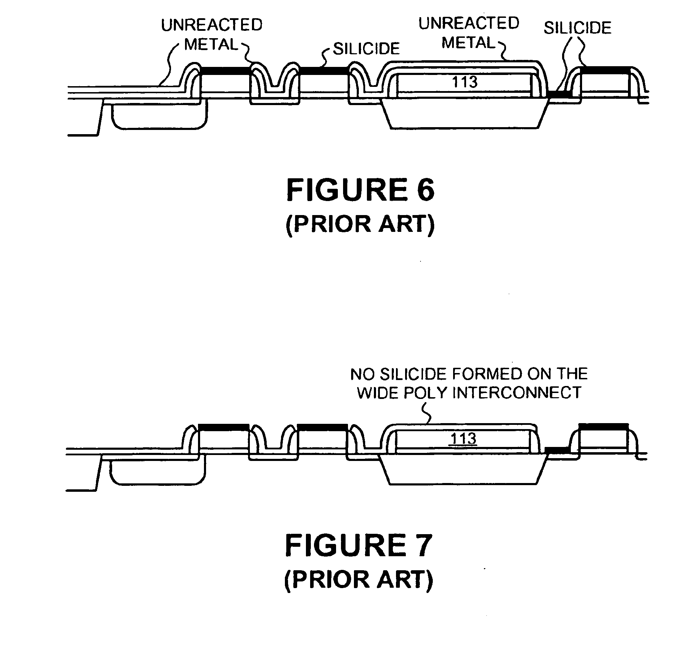

A prior art process for a metal salicide used in an image sensor is shown in Figures 1-7. Turning to Figure 1, a cross-section of an image sensor shows an array section 101 and a periphery section 103. The array section 101 includes the pixel array and various interconnect resources. The periphery section 103 includes logic, timing circuits, control circuits, signal processing, and the like used to control and read out the signal from the array section 101. Note that the cross-sectional view of Figure 1 is of a four-transistor pixel, but other pixel designs may also be used.

The prior art salicide formation process is typically performed after the spacer etch and the implant steps have been completed. Because the implant step requires high temperatures to activate the dopants, these high temperatures would damage the salicide. Moreover, without the spacers in place, there would be short circuits between the source and drain regions with the transistor gates. Thus, the salicide process is typically performed after the pixels have been formed.

As seen in Figure 1, in accordance with the prior art, an insulator layer 115 is deposited over the array section 101 and the periphery section 103. Then, as seen in Figure 2, an organic film 201 (such as a photoresist or bottom anti-reflective coating) is formed over the insulator layer 115. Because of the uneven surface of the image sensor (caused by various underlying transistor or interconnect structures), the deposited film 201 is not uniform.

Low-lying areas such as the photodiode and source/drain regions are covered with a thick organic film. Over the gate regions and polysilicon interconnect structure 113, the thickness of the organic film 201 depends on the size of those polysilicon features. On larger features, the organic film 201 can reach its full thickness approximately equal to the thickness over the photodiode areas. However, over smaller features, such as the transfer gate and reset gate of the pixel, the organic film 201 is thinner.

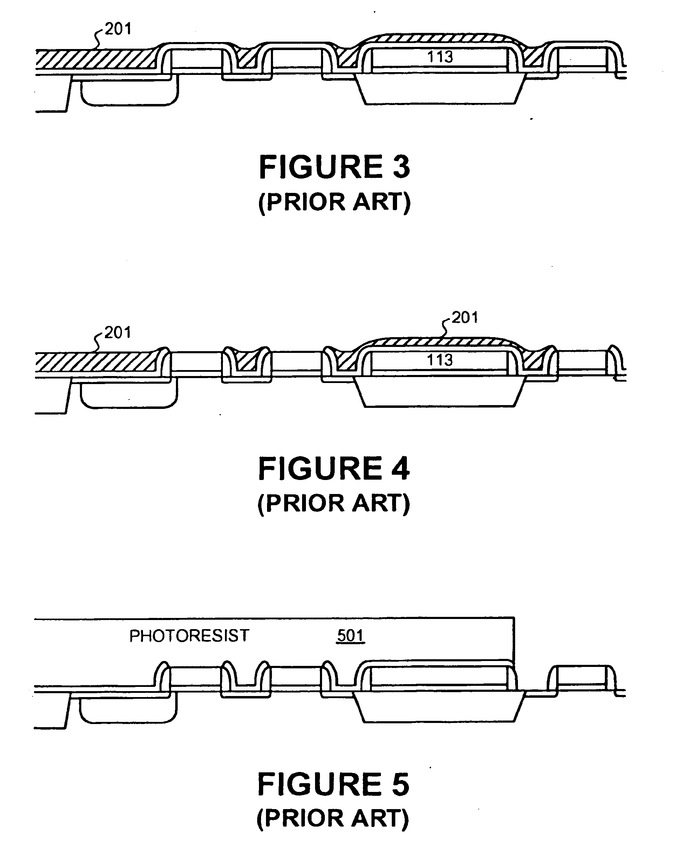

Turning to Figure 3, according to the prior art process, an etchback step is performed to remove a portion of the organic film 201. However, there remains a portion of the organic film 201 over the polysilicon interconnect region 113. If the etching time is increased to remove this organic film over the polysilicon interconnect 113, then the organic film 201 that is over the photodiode may also be removed.

The Figures and description herein is but one example of the problem. The wide polysilicon interconnect 113 may be part of a long interconnect linking the transfer gates to periphery driver circuits. It may also be a long, wide interconnect for the reset or row select gates. In all of these cases, there is the issue that current manufacturing processes do not have the process margin to guarantee that the organic film 201 remains over the photodiode, while being completely removed over the polysilicon interconnect 113.

Figures 4-7 further illustrate the limitations of the prior art. Specifically, in Figure 4, the exposed insulator layer 115 is removed. The insulator layer 115 could be, for example, silicon dioxide. The removal can be done using a wet etch (HF etchant) process or a dry etch process which, for example, would be a plasma process using a fluorine-containing gas.

Figure 4 shows that the organic film 201 remains in place while the oxide over the transistor gates are removed. The removal of the oxide layer 115 is intended to keep the photodiode region protected while allowing the polysilicon gates to be exposed. As seen in Figure 4, because the organic layer 201 remains atop of the polysilicon interconnect structure 113, the oxide layer 115 over the polysilicon interconnect structure 113 remains.

After removal of the organic layer 201, as seen in Figure 5, a photoresist layer 501 is patterned such that the insulator layer 115 in the periphery section 103 is removed. After the photoresist layer 501 is stripped, a metal such as titanium, cobalt, or nickel, is deposited. The image sensor is then exposed to a heat source and where the metal is in contact with silicon, a metal salicide is formed as shown in Figure 6. The unreacted metal can be removed using selective wet etchants, such as APM (ammonium hydroxide and hydrogen peroxide mixture). The result of the selective removal of the unreactant metal is shown in Figure 7. At this point, the difficulty with the prior art is clearly evident. There is no salicide formed over the wide polysilicon interconnect 113 in the array.

In a first aspect, the present invention provides a method of forming a silicide for a pixel array according to Claim 1. Further advantageous embodiments are recited in the dependent claims.

### BRIEF DESCRIPTION OF THE DRAWINGS

Figures 1-7 are cross-sectional views illustrating a prior art method for forming a salicide structure in a CMOS image sensor.

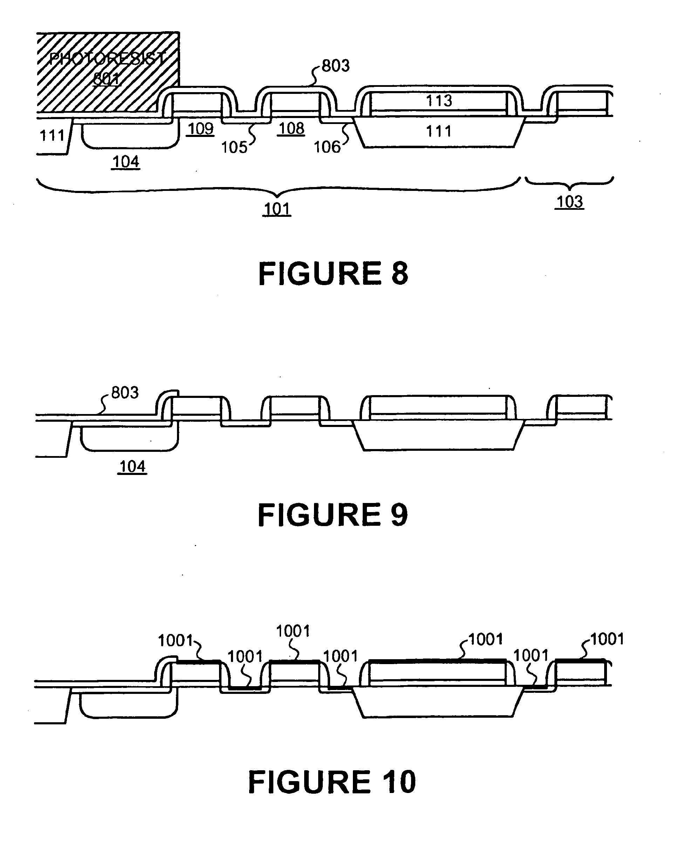

Figures 8-12 are cross-sectional views illustrating a method in accordance with the present invention for forming a salicide structure in a CMOS image sensor.

### DETAILED DESCRIPTION

In the following description, numerous specific details are provided in order to give a thorough understanding of embodiments of the invention. One skilled in the relevant art will recognize, however, that the invention may be practiced without one or more of the specific details, or with other methods, components, materials, etc. In other instances, well known structures, materials, or operations are not shown or described in order to avoid obscuring aspects of the invention.

References throughout the specification to "one embodiment" or "an embodiment" means that a particular feature, structure, or characteristic described in connection with the embodiment and included in at least one embodiment of the present invention. Thus, the appearances of the phrase "in one embodiment" or "in an embodiment" in various places throughout the specification are not necessarily all referring to the same embodiment. Furthermore, the particular features, structures, or characteristics may be combined in any suitable manner in one or more embodiments.

Turning to Figure 8, a cross-sectional view of a representative CMOS image sensor is shown. Like Figure 1 described above, the image sensor includes a pixel array section 101 and a periphery section 103. While Figure 8 (and the following figures) illustrates a cross-sectional view of a four transistor (4T) pixel design, the teachings and structures of the present invention can be equally applied to CMOS image sensors using 3T, 5T, 6T, 7T, or any other pixel design. For example, the present invention may be used in connection with pixels that include a reset transistor, a row select transistor, a global shutter transistor, a high dynamic range transistor, a transistor connected to a lateral overflow drain (lateral overflow transistor), or a transistor used to switch the floating diffusion (floating diffusion switch transistor).

It should be noted that the teachings of the present invention may be applied to any integrated circuit that has formed a silicide structure. The application of the present invention to a CMOS image sensor is meant to provide only a single example of how the present invention may be applied. As will be seen below, the present invention may be generalized as follows: (1) an insulator layer is formed over an underlying substrate with various raised silicon and/or polysilicon features; (2) an organic layer is formed over the insulator layer that is patterned to protect certain sensitive regions; (3) an etching step is performed to remove the insulator layer from the unprotected raised features; (4) a metal layer is deposited over the top surface of the raised features; (5) an anneal is performed to form a metal silicide where the metal layer contacts the top surface of the silicon and/or polysilicon; and (6) the unreacted metal layer is removed.

Returning to the description of the specific application of the present invention to a CMOS image sensor, in the 4T design shown in Figure 8, the pixel array section 101 (showing a single pixel) includes a photosensor 104, a reset transistor 108, a transfer transistor 109, a floating node 105, an n+ diffusion 106 connected to the V_{dd} supply voltage (not shown), a polysilicon interconnect 113, and shallow trench isolation (STI) regions 111. The photosensor 104 may be a photodiode, a photogate, or a photoconductor.

Note that Figure 8 only shows a portion of a 4T pixel and that other components (such as the amplification transistor) are not shown for clarity purposes. The other components and operation of the pixel are not particularly germane to the present invention and are well known by those of ordinary skill in the art.

Similarly, in the periphery section 103, a single transistor is shown in cross section. This transistor is meant to be exemplary of the types of circuits and devices formed in the periphery. Thus, the transistor is merely representative of the types of devices existing in the periphery section 103.

As seen in Figure 8, an insulator layer 803 is blanket deposited onto the CMOS image sensor. The insulator layer 803 can be deposited using various deposition technologies, such as chemical vapor deposition (CVD), plasma enhanced chemical vapor deposition (PECVD), or high density plasma chemical vapor deposition (HDPCVD). In one embodiment, the insulator layer 803 is an oxide. After the formation of the insulator layer 803, a photoresist layer 801 is patterned such that the photodiode 104 is protected. The transistors (108, 109, and the periphery region) and polysilicon interconnect 113 are exposed.

Then, as seen in Figure 9, a portion of the insulator layer 803 is removed using the photoresist 801 as a mask. The insulator layer 803 remains over the photodiode 104. The insulator layer 803 may be removed using a wet etchant such as HF. Alternatively, a dry etch using a fluorine gas may be used in a plasma process.

Next, turning to Figure 10, a process, such as sputtering, is used to deposit a layer of metal over the image sensor. While the layer of metal can be any one of the types of metals used in semiconductor processing, such as nickel, cobalt, tungsten, titanium, or molybdenum, in one embodiment, the metal is formed from cobalt. Note that because the insulator layer 803 has been removed, the metal can directly contact the polysilicon layers, as well as the source and drain regions of the transistors.

Still referring to Figure 10, a thermal anneal is performed to cause the metal to interact with the exposed silicon substrate and the exposed polysilicon gates. This results in the formation of a salicide 1001 on those regions where the metal and silicon (or polysilicon) are in contact.

Next, while not shown in Figure 10, the metal is then removed. This can be done, for example, using an appropriate wet etching technique. One example of such a wet etching would be NH₄OH (ammonium hydroxide) in H₂O₂ (hydrogen peroxide).

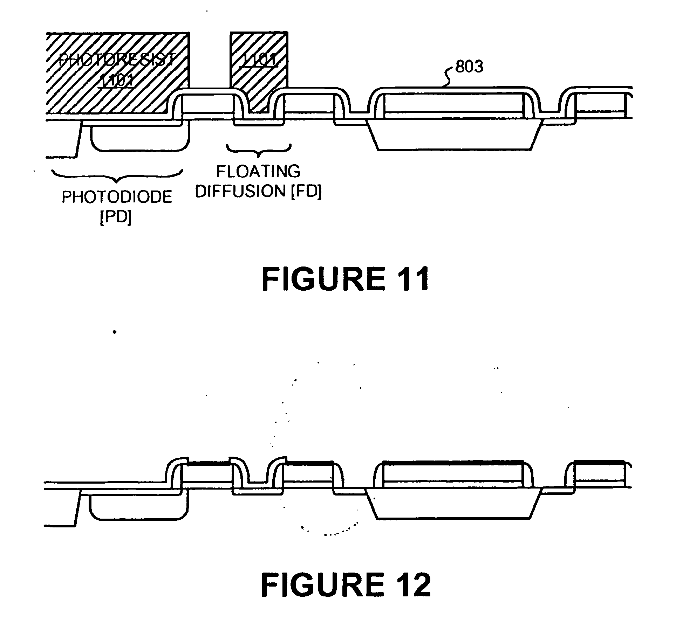

In an alternative embodiment shown in Figures 11 and 12, a photoresist layer 1101 not only covers the photodiode, but also the floating diffusion (floating node) 105. The floating node 105 is a region that is required to have a low junction leakage to enhance image sensor performance. As such, it would be advantageous to protect the floating node as well. Thus, after removal of portions of the insulator layer 803, the floating node 105 and the photodiode 104 still have the protective insulator layer 803 formed thereon. The resulting structure, after metal deposition, reaction, and removal is seen in Figure 12.

As can be seen by the above description and Figures, a self-aligned silicide (salicide) process is disclosed that is consistent with a conventional CMOS image sensor process flow. As noted previously, it is possible to use many types of metal, or even alloys of metal. For example, titanium/tungsten, titanium/molybdenum, cobalt/tungsten, or cobalt/molybdenum may be used.

From the foregoing, it will be appreciated that specific embodiments of the invention have been described herein for purposes of illustration, but that various modifications may be made without deviating from the spirit and scope of the invention. For example, the present invention has been described using a salicide, but the invention may be applied to a silicide structure and the two terms as used herein are interchangeable. As a further example, while the present invention has been described in conjunction with a CMOS image sensor, the present invention may be used with other types of solid state sensors, such CCDs. Accordingly, the invention is not limited except as by the appended claims.

## Claims

1. A method of forming a silicide for a pixel array formed in a silicon substrate, said pixel array having photosensitive regions (104) and polysilicon structures (108, 109, 113) adjacent to said photosensitive regions the method comprising:
forming an insulator layer, (803) over said pixel array; the insulator layer covering said photosensitive regions and said polysilicon structures;
forming a photoresist (801) over said insulator layer, said photoresist protecting at least the photosensitive regions of said pixel array while exposing said polysilicon structures (108, 109, 113);
using said photoresist as a mask to remove portions of said insulator layer to expose said polysilicon structures and a portion of said silicon substrate;
forming a metal layer over remaining portions of said insulator layer, said polysilicon structures, and said portion of said silicon substrate; and
forming a metal silicide (1001) by annealing said metal layer, said metal silicide being formed where said metal layer contacts said silicon substrate and said polysilicon structures.

2. The method of Claim 1 further including the step of removing said metal layer that is not reacted to form said metal silicide.

3. The method of Claim 1 wherein said insulator layer is an oxide layer.

4. The method of Claim 1 wherein said metal layer is cobalt, nickel, titanium, molybdenum, tantalum, or tungsten, or alloys thereof.

5. The method of Claim 1 wherein said pixel array is comprised of pixels that include a floating diffusion (106).

6. The method of Claim 5 wherein said photoresist also protects said floating diffusion.

7. The method of Claim 1 wherein said polysilicon structures include a polysilicon interconnect (113).

8. The method of Claim 5 wherein said pixels include a reset transistor (108) and a transfer transistor (109) having gates formed from polysilicon and said insulator layer is removed from top portions of said gates using said photoresist as a mask.

9. The method of claim 1 wherein said pixel array is contained in an image sensor, said image sensor having a pixel array section and a periphery section,
wherein forming on insulator layer includes
forming an insulator layer over said pixel array section and said periphery section.

## Patentansprüche

1. Verfahren zur Ausbildung eines Silicids für eine in einem Siliciumsubstrat ausgebildete Pixelmatrix, wobei die Pixelmatrix lichtempfindliche Bereiche (104) und an die lichtempfindlichen Bereiche angrenzende Polysiliciumstrukturen (108, 109, 113) aufweist, wobei das Verfahren Folgendes umfasst:
die Ausbildung einer Isolationsschicht (803) über der Pixelmatrix, wobei die Isolationsschicht die lichtempfindlichen Bereiche und die Polysiliciumstrukturen abdeckt;
die Ausbildung eines Photoresists (801) über der Isolationsschicht, wobei das Photoresist zumindest die lichtempfindlichen Bereiche der Pixelmatrix schützt, während die Polysiliciumstrukturen (108, 109, 113) freiliegen;
die Verwendung des Photoresists als Maske zur Entfernung von Teilen der Isolationsschicht, um die Polysiliciumstrukturen und einen Teil des Siliciumsubstrats freizulegen;
die Ausbildung einer Metallschicht über den verbleibenden Teilen der Isolationsschicht, den Polysiliciumstrukturen und dem Teil des Siliciumsubstrats; und
das Ausbilden eines Metallsilicids (1001) durch das Tempern der Metallschicht, wobei das Metallsilicid dort ausgebildet wird, wo die Metallschicht das Siliciumsubstrat und die Polysiliciumstruktren berührt.

2. Verfahren nach Anspruch 1, ferner umfassend den Schritt des Entfernens der nicht umgesetzten Metallschicht zur Ausbildung des Metallsilicids.

3. Verfahren nach Anspruch 1, worin die Isolationsschicht eine Oxidschicht ist.

4. Verfahren nach Anspruch 1, worin die Metallschicht aus Kobalt, Nickel, Titan, Molybdän, Tantal, Wolfram oder Legierungen davon besteht.

5. Verfahren nach Anspruch 1, worin die Pixelmatrix aus Pixeln besteht, die eine schwebende Diffusion (106) umfassen.

6. Verfahren nach Anspruch 5, worin das Photoresist auch die schwebende Diffusion schützt.

7. Verfahren nach Anspruch 1, worin die Polysiliciumstrukturen eine Polysiliciumzwischenverbindung (113) umfassen.

8. Verfahren nach Anspruch 5, worin die Pixel einen Rückstelltransistor (108) und einen Transfertransistor (109) mit aus Polysilicium ausgebildeten Gates umfassen und die Isolationsschicht unter Verwendung des Photoresists als Maske von den oberen Teilen der Gates entfernt wird.

9. Verfahren nach Anspruch 1, worin die Pixelmatrix in einem Bildsensor enthalten ist, wobei der Bildsensor einen Pixelmatrixabschnitt und einen Umfangsabschnitt aufweist, wobei das Ausbilden einer Isolationsschicht das Ausbilden einer Isolationsschicht über dem Pixelmatrixabschnitt und dem Umfangsabschnitt umfasst.

## Revendications

1. Procédé de formation d'un siliciure pour un groupement de pixels formé dans un substrat de silicium, ledit groupement de pixels ayant des régions photosensibles (104) et des structures en polysilicium (108, 109, 113) adjacentes auxdites régions photosensibles, le procédé comprenant:
former une couche d'isolateur (803) sur ledit groupement de pixels, la couche d'isolateur couvrant lesdites régions photosensibles et lesdites structures en polysilicium;
former un photorésist (801) sur ladite couche d'isolation, ledit photorésist protégeant au moins les régions photosensibles dudit groupement de pixels tout en exposant lesdites structures en polysilicium (108, 109, 113);
utiliser ledit photorésist comme un masque pour retirer des portions de ladite couche d'isolateur pour exposer lesdites structures en polysilicium et une portion dudit substrat de silicium;
former une couche métallique sur les portions restantes de ladite couche d'isolateur, lesdites structures en polysilicium et ladite portion dudit substrat de silicium; et
former un siliciure métallique (1001) en recuisant ladite couche métallique, ledit siliciure métallique étant formé à l'endroit où ladite couche métallique vient en contact avec ledit substrat en silicium et lesdites structures en polysilicium.

2. Procédé selon la revendication 1, comprenant en outre l'étape consistant à retirer ladite couche métallique qui n'a pas réagi pour former ledit siliciure métallique.

3. Procédé selon la revendication 1, dans lequel ladite couche d'isolateur est une couche d'oxyde.

4. Procédé selon la revendication 1, dans lequel ladite couche métallique est du cobalt, nickel, titane, molybdène, tantale ou tungstène ou des alliages de ceux-ci.

5. Procédé selon la revendication 1, dans lequel ledit groupement de pixels est constitué de pixels qui comportent une diffusion flottante (106).

6. Procédé selon la revendication 5, dans lequel ledit photorésist protège également ladite diffusion flottante.

7. Procédé selon la revendication 1, dans lequel lesdites structures en polysilicium comportent une interconnection de polysilicium (113).

8. Procédé selon la revendication 5, dans lequel lesdits pixels comportent un transistor de remise à l'état initial (108) et un transistor de transfert (109) ayant des grilles formées en polysilicium, et ladite couche d'isolateur est retirée des portions supérieures desdites grilles en utilisant ledit photorésist comme un masque.

9. Procédé selon la revendication 1, dans lequel ledit groupement de pixels est centré comme un capteur d'images, ledit capteur d'images ayant une section de groupement de pixels et une section de périphérie,
où la formation sur la couche isolateur comporte la formation d'une couche d'isolateur sur ladite section de groupement de pixels et ladite section périphérique.
